(19) Europäisches Patentamt
European Patent Office
Office européen des brevets

(11) EP 0 826 985 A1

(12) **EUROPEAN PATENT APPLICATION**

(43) Date of publication:
**04.03.1998 Bulletin 1998/10**

(51) Int Cl.6: **G02B 1/10**

(21) Application number: **97306379.5**

(22) Date of filing: **21.08.1997**

(84) Designated Contracting States:
**AT BE CH DE DK ES FI FR GB GR IE IT LI LU MC NL PT SE**

(30) Priority: **28.08.1996 US 697633**

(71) Applicant: **Applied Materials, Inc.**
**Santa Clara, California 95054 (US)**

(72) Inventors:
- **LaCourt, David W.**
  **San Rafael, CA 94903 (US)**
- **Yam, Mark**
  **San Jose, CA 95124 (US)**
- **Lalezari, Ramin**
  **Boulder, CO 80301 (US)**
- **Long, Dale**
  **Lafayette, CO 80026 (US)**

(74) Representative: **Allard, Susan Joyce et al**
**BOULT WADE TENNANT,**
**27 Furnival Street**
**London EC4A 1PQ (GB)**

(54) **Reflector for a semiconductor processing chamber**

(57) A reflector (10) disposed in a semiconductor processing chamber (12) comprising a reflector substrate (20), an aluminum reflecting layer (23) disposed on the substrate (20), and a reflectivity-enhancing coating (25) disposed on the aluminum layer (23), wherein a mechanical bond is formed between the aluminum layer (23) and the reflectivity-enhancing coating (25).

The present invention provides a reflector (10) having a reflectivity-enhancing coating (25) that is resistant to delamination from the reflector (10), even under thermal cycling conditions present in a semiconductor processing chamber (12). The reflector (10) is also highly reflective, relatively inexpensive to manufacture and minimizes introduction of contaminants into the chamber (12).

FIG. 1.

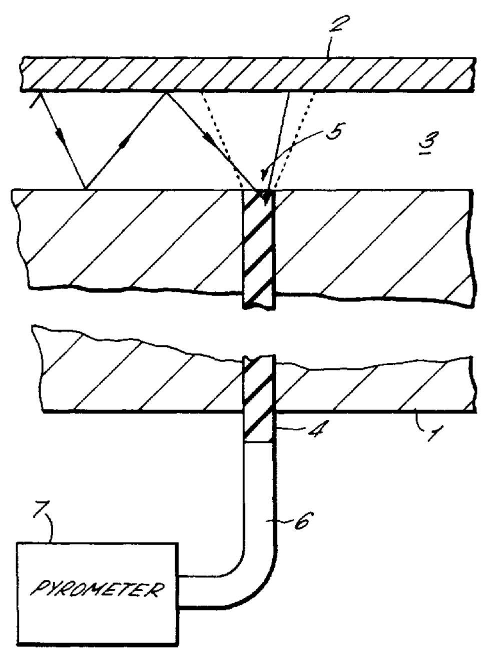


EP 0 826 985 A1

## Description

The invention relates to a reflector disposed in a semiconductor processing chamber.

In many semiconductor device manufacturing processes, the required high levels of device performance, yield, and process repeatability can only be achieved if the temperature of a substrate (e.g., a semiconductor wafer) is tightly controlled during processing. To achieve that level of control, it is often necessary to measure the substrate temperature in real time and *in situ,* so that any unexpected temperature variations can be immediately detected and corrected.

For example, consider rapid thermal processing (RTP), which is used for several different fabrication processes, including rapid thermal annealing (RTA), rapid thermal cleaning (RTC), rapid thermal chemical vapor deposition (RTCVD), rapid thermal oxidation (RTO), and rapid thermal nitridation (RTN). In the particular application of complementary metal-oxide-semiconductor (CMOS) gate dielectric formation by RTO or RTN, thickness, growth temperature, and uniformity of the gate dielectrics are critical parameters that influence the overall device performance and fabrication yield. Currently, CMOS devices are being made with dielectric layers that are only 60-80 angstroms (Å) thick and for which thickness uniformity must be held within ±2 Å. This level of uniformity requires that temperature variations across the substrate during high temperature processing cannot exceed a few degrees Centigrade (°C).

The wafer itself often cannot tolerate even small temperature differentials during high temperature processing. If the temperature difference is allowed to rise above 1-2°C/cm at 1200 °C, the resulting stress is likely to cause slip in the silicon crystal. The resulting slip planes will destroy any devices through which they pass. To achieve that level of temperature uniformity, reliable real-time, multi-point temperature measurements for closed-loop temperature control are necessary.

Optical pyrometry is widely used for measuring temperatures in RTP systems. Pyrometry exploits a general property of objects, namely, that objects emit radiation with a particular spectral content and intensity that is characteristic of their temperature. Thus, by measuring the emitted radiation, the objects' temperature can be determined. A pyrometer measures the emitted radiation intensity and performs the appropriate conversion to obtain temperature (T). The relationship between spectral emitted intensity and temperature depends on the spectral emissivity of the substrate and the ideal blackbody radiation-temperature relationship, given by Planck's law:

$$I_b(\lambda, T) = \frac{2C_1}{\lambda^5\left(e^{\frac{C_2}{\lambda T}} - 1\right)} \qquad (1)$$

where $C_1$ and $C_2$ are known constants, $\lambda$ is the radiation wavelength of interest, and T is the substrate temperature measured in °K. According to an approximation known as Wein's distribution law, this expression can be rewritten as follows:

$$I_b(\lambda, T) \approx K(\lambda) \cdot e^{\frac{C_2}{\lambda T}} \qquad (2)$$

where $K(\lambda) = 2C_1/\lambda'$. This is a good approximation for temperatures below about 2700°C.

The spectral emissivity $e(\lambda,T)$ of an object is the ratio of its emitted spectral intensity $I(\lambda,T)$ to that of a blackbody at the same temperature $I_b(\lambda,T)$. That is,

$$e = \frac{I(\lambda, T)}{I_b(\lambda, T)} . \qquad (3)$$

Since $C_1$ and $C_2$ are known constants, under ideal conditions, the temperature of the wafer can be accurately determined if $e(\lambda,T)$ is known.

However, prior art optical pyrometers suffer from limitations due to an inability to accurately measure the emissivity of the substrate. Moreover, even if the emissivity of the substrate is known at a given temperature, it may change with temperature. The changes are usually not accurately measurable and thus they introduce an unknown error into the temperature measurements. Errors on the order of 10°C or more are not uncommon.

The spectral emissivity of a substrate depends on many factors, including the characteristics of the wafer itself (e.g., temperature, surface roughness, doping level of various impurities, material composition, and thickness of surface layers) and the process history of the wafer. Another related term is the effective emissivity of an object. The effective

emissivity is the ratio of the measured spectral intensity emitted by the object to that of a blackbody at the same temperature. The effective emissivity of an object differs from the spectral emissivity for the same object in that the effective emissivity takes into account the environment in which the object resides. The effective emissivity of a substrate may be influenced by the characteristics of the process chamber in which the substrate is positioned. Therefore, a *priori* estimation of substrate emissivity cannot provide a general purpose pyrometric temperature measurement capability.

An approach for improving the accuracy of pyrometric temperature measurement is described in co-pending U.S. Patent Application Serial No. 08/641,477, entitled "METHOD AND APPARATUS FOR MEASURING SUBSTRATE TEMPERATURES", filed on May 1, 1996 and assigned to the assignee of the subject application, which is incorporated herein by reference. In this approach, a thermal reflector is placed near the substrate to reduce the sensitivity of the measured temperature to substrate emissivity.

An apparatus employing this approach is shown in Figure 1. In this figure, a thermal reflector 1 is positioned near a substrate 2 to create a virtual blackbody cavity 3 between the reflector and the substrate. If the substrate backside is diffuse, the radiation is emitted from it in a random pattern and thus the emitted radiation is reflected throughout the cavity in an equally random (isotropic) pattern. The radiation arriving at any location on the surface of reflector 1 is made up of many components: one component is made up of the radiation coming directly from the substrate and has experienced no reflections; a second component has experienced only one reflection off of reflector 1 and the backside of substrate 2; a third component has experienced two reflections off of reflector 1 and the backside of substrate 2, etc. The total intensity available at a point on the reflector plate can be found by summing over an infinite series of components of impinging radiation as follows:

$$I_T = e \cdot \sigma \cdot T^4 \cdot \sum_n R^n \cdot (1-e)^n \qquad (4A)$$

$$I_T = \frac{e \cdot \sigma \cdot T^4}{1 - R(1-e)} \qquad (4B)$$

where the reflectivity of the cold reflector plate is given by R, the emissivity of the wafer by ε and where σ is the Stefan-Boltzman constant and T is the temperature of the substrate.

Assuming that the reflectivity of the reflector is equal to one (R=1), then Eq. 4B reduces to:

$$I_T = \sigma T^4 , \qquad (4C)$$

in which the radiation $I_T$ is <u>independent</u> of emissivity of the backside of the substrate. Stated differently, the reflector produces a virtual blackbody cavity for which the "effective emissivity" of the substrate is equal to one.

Note that this emissivity enhancing effect does not require that the backside of the wafer be diffuse. It will work for substrates having backsides that are perfectly specular reflectors as well as for substrates having backsides that are highly diffuse. As noted above, semiconductor wafer backsides are some combination of diffuse and specular.

A light pipe 4 is used to sample radiation in the cavity through an aperture 5 in the reflector. The sampled intensity is passed through an optical fiber 6 to a pyrometer 7 where it is converted to temperature by using Eq. 4C, above. Because of the virtual blackbody cavity effect, the measured temperature will be independent of changes in emissivity of the substrate.

For the apparatus to provide accurate temperature measurements, the reflectivity of the reflector should be as close to one as possible. The effect of reflectivity on the sensitivity of temperature measurements to variations in substrate emissivity can be seen from the equation:

$$\frac{\Delta T}{T} = \frac{\lambda \cdot T}{C_2} \cdot \frac{\left(1 - R_{eff}\right)}{\left\{1 - R_{eff} \cdot (1-e)\right\}} \cdot \frac{\Delta e}{e} , \qquad (5)$$

where $R_{eff}$ is the effective reflectivity of the reflecting cavity, which takes into account the geometry of the reflector and cavity together with the actual reflectivity of the reflector. From this equation, it can be seen that as $R_{eff}$ approaches one, the numerator and thus, the sensitivity of the measured temperature to changes in substrate emissivity, become vanishingly small.

Due to its high reflectivity for infrared radiation, gold is a material highly suitable for use in a reflector. A reflector using a gold layer is described in the above-mentioned U.S. Patent Application Serial No. 08/641,477. The reflector consists of a reflector substrate and a highly reflective surface coating on top of the reflector substrate. The reflector substrate is made of aluminum. The bottom layer of the coating is a metallic reflecting layer made of gold, which is deposited onto the surface of the reflector substrate. To enhance the reflectivity of the gold layer, a dielectric stack is formed on top of the gold layer. The dielectric stack is made up of alternating dielectric layers which have different indices of refraction and have a thickness equal to one-quarter of the wavelength of interest.

When the dielectric stack is formed from alternating layers of silicon dioxide and titanium dioxide, the reflector has a reflectivity of 0.99 at 950 nanometers (nm), which is significantly higher than the natural reflectivity of gold of 0.975. Since the reflectivity of the reflector is very close to one, substrate temperature measurement using this reflector is virtually insensitive to substrate emissivity and is thus very accurate.

The adhesion between the gold layer and the dielectric stack of the reflector is, however, relatively weak. If the reflector is subjected to thermal cycling as may occur in a semiconductor processing chamber, such as an RTP chamber, the dielectric stack may peel or delaminate from the reflector, reducing the reflectivity of the reflector. As a result, substrate temperature measurement becomes more sensitive to substrate emissivity, which decreases the accuracy of the temperature measurement.

The gold layer of the reflector is also a potential source of contamination in a semiconductor processing chamber, since gold is not a material typically present in the chamber. Furthermore, since gold is a relatively expensive material, the use of a gold layer in the reflector significantly increases the cost of the reflector.

Therefore, an object of the present invention is to provide a reflector having a reflectivity-enhancing coating that is resistant to delamination yet also having a high level of reflectivity.

Another object of the present invention is to provide a reflector that minimizes introduction of contaminants in a semiconductor processing chamber.

A further object of the present invention is to provide a reflector that is relatively inexpensive to manufacture.

Additional objects and advantages of the invention will be set forth in the description which follows, and in part will be obvious from the description, or may be learned by practice of the invention. The objects and advantages of the invention may be realized and obtained by means of the instrumentalities and combinations particularly pointed out in the claims.

The present invention is directed to a reflector disposed in a semiconductor processing chamber comprising a reflector substrate, an aluminum reflecting layer disposed on the substrate, and a reflectivity-enhancing coating disposed on the aluminum layer, wherein a mechanical bond is formed between the aluminum layer and the reflectivity-enhancing coating. An adhesion layer may optionally be disposed between the aluminum layer and the substrate and reflectivity-enhancing coating.

The present invention provides several advantages. First, the reflector of the present invention is resistant to delamination of the reflectivity-enhancing coating yet also provides a high reflectivity. Second, the reflector minimizes contamination of the semiconductor processing chamber due to the use of aluminum rather than gold for the reflecting layer. Third, the reflector is relatively inexpensive to manufacture, again due to the use of aluminum for the reflecting layer.

Due to its high reflectivity and resistance to delamination, the reflector of the present invention is suitable for use with pyrometric temperature measurement techniques in an RTP chamber. Other potential applications of the reflector include placement along the inner walls of a semiconductor processing chamber to reduce energy loss or to reduce the local variations in a process caused by patterns etched on a substrate.

The accompanying drawings, which are incorporated in and constitute a part of the specification, schematically illustrate a preferred embodiment of the invention and, together with the general description given above and the detailed description of the preferred embodiment given below, serve to explain the principles of the invention.

Figure 1 is a cross-sectional side view of a substrate temperature measuring apparatus in which a reflector is positioned near a substrate.

Figure 2 is a cross-sectional side view of a substrate temperature measuring apparatus in accordance with the present invention.

Figure 3 is a cross-sectional side view of a reflector in accordance with the present invention.

As shown in Figure 2, a reflector 10 is positioned near a semiconductor substrate 11 in an RTP chamber 12, forming a virtual blackbody cavity 13. A light pipe 14 is used to sample electromagnetic radiation in the cavity through an aperture 15 in the reflector. The sampled radiation is passed through an optical fiber 16 to a pyrometer 17 where it is converted to temperature by using Eq. 4C, above.

Referring to Figure 3, reflector 10 includes a reflector substrate 20 composed, for instance, of aluminum. A nickel layer 21 may optionally be disposed on the substrate.

An adhesion layer 22 may optionally be disposed on nickel layer 21, although the adhesion layer is preferably omitted. The adhesion layer improves the adhesion of an aluminum layer 23 to nickel layer 21 and inhibits the oxidation

of the aluminum layer. The adhesion layer may be composed of a fluoride, such as aluminum fluoride or magnesium fluoride, a nitride, such as aluminum nitride or silicon nitride, or an oxide, such as aluminum oxide or titanium dioxide.

Aluminum layer 23 is disposed on adhesion layer 22. Aluminum layer 23 provides reflector 10 with a highly reflective surface. The aluminum layer may be composed of pure aluminum or an aluminum alloy. The aluminum layer may have a thickness, for instance, of 700 to 1000 Å.

An adhesion layer 24 may optionally be disposed on aluminum layer 23, although the adhesion layer is preferably omitted. The adhesion layer improves the adhesion of a reflectivity-enhancing coating 25 to the aluminum layer and inhibits the oxidation of the aluminum layer. The adhesion layer may be composed of a fluoride, such as aluminum fluoride or magnesium fluoride, a nitride, such as aluminum nitride or silicon nitride, or an oxide, such as aluminum oxide or titanium dioxide.

Reflectivity-enhancing coating 25 is disposed on aluminum layer 23, or if present, adhesion layer 24. The reflectivity-enhancing coating enhances the reflectivity of aluminum layer 23, while also further protecting the aluminum layer from oxidation. The reflectivity-enhancing coating may be a dielectric stack made of alternating dielectric layers with different indices of refraction. The dielectric layers may be composed of alternating layers of, for instance, silicon dioxide and either titanium dioxide or tantalum pentoxide. The dielectric layers have a thickness equal to one-quarter the wavelength of interest, which may be, for instance, 950 nm.

Reflectivity-enhancing coating 25 strongly adheres to aluminum layer 23 by means of a mechanical bond formed therebetween due to the affinity of aluminum for oxides. As a result, reflectivity-enhancing coating 25 is resistant to delamination from reflector 10, even under the severe thermal cycling conditions that may be present in a semiconductor processing chamber, such as an RTP chamber.

Finally, an encapsulation layer 26 is disposed on reflectivity-enhancing coating 25. The encapsulation layer prevents the metal of aluminum layer 23 from dispersing and possibly contaminating the RTP chamber. The encapsulation layer may be composed of silicon dioxide, aluminum oxide, silicon nitride, or any other acceptable material that will passivate the reflecting layer without degrading its reflective properties at the wavelength of interest. Encapsulation layer 26 has a thickness equal to one-half the wavelength of interest or some multiple thereof. The encapsulation layer may be formed out of, for instance, two quarter-wave thick layers of silicon dioxide.

The reflectivity of reflector 10 is about 0.99 at 950 nm, which is significantly higher than the natural reflectivity of 0.90 for an aluminum film and is virtually the same as that of a reflector using a gold film.

Reflector 10 may be fabricated using the following steps. First, nickel layer 21 is deposited on substrate 20 using a chemical, or "electroless", plating process. Second, adhesion layer 22 is optionally deposited on nickel layer 21 using a process such as chemical vapor deposition (CVD) or thermal oxidation. Third, aluminum layer 23 is deposited on nickel layer 21 or adhesion layer 22 using a process such as evaporation or sputtering. Fourth, adhesion layer 24 is optionally deposited on aluminum layer 23 using a process such as CVD or thermal oxidation. Fifth, reflectivity-enhancing coating 25 is deposited on aluminum layer 23 or adhesion layer 24 using a process such as evaporation or sputtering. Finally, encapsulation layer 26 is deposited on reflectivity-enhancing coating 25 using a process such as CVD or oxidation.

The present invention has been described in terms of a preferred embodiment. The invention, however, is not limited to the embodiment depicted and described. Rather, the scope of the invention is defined by the appended claims.

## Claims

1. A reflector disposed in a semiconductor processing chamber, comprising:

   a reflector substrate;
   an aluminum layer disposed on said substrate;
   a reflectivity-enhancing coating disposed on said aluminum layer; and
   wherein a mechanical bond is formed between said aluminum and said reflectivity-enhancing coating.

2. A reflector as claimed in claim 1, wherein said semiconductor processing chamber is a rapid thermal processing chamber.

3. A reflector as claimed in claim 1 or claim 2, wherein said substrate is composed of aluminum.

4. A reflector as claimed in any one of claims 1 to 3, wherein said aluminum layer is composed of pure aluminum.

5. A reflector as claimed in any one of claims 1 to 4, wherein said reflectivity-enhancing coating is composed of at least two dielectric oxide layers.

**6.** A reflector as claimed in any one of claims 1 to 5, further comprising a first adhesion layer disposed between said reflector substrate and said aluminum layer.

**7.** A reflector as claimed in claim 6, wherein said first adhesion layer is composed of a material selected from the group consisting of fluorides, nitrides and oxides.

**8.** A reflector as claimed in claim 6, wherein said first adhesion layer is composed of titanium dioxide.

**9.** A reflector as claimed in any one of claims 1 to 8, further comprising a second adhesion layer disposed between said aluminum layer and said reflectivity-enhancing coating.

**10.** A reflector as claimed in claim 9, wherein said second adhesion layer is composed of a material selected from the group consisting of fluorides, nitrides and oxides.

**11.** A reflector as claimed in claim 9, wherein said second adhesion layer if composed of titanium oxide.

FIG. 1.

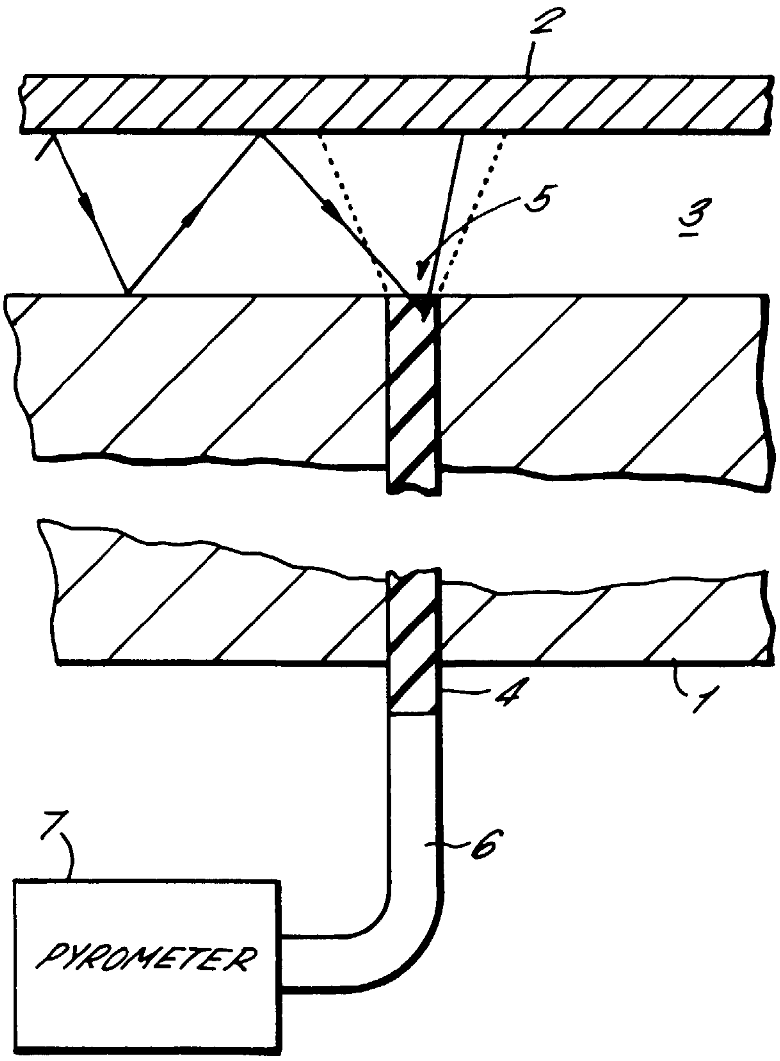

FIG. 2.

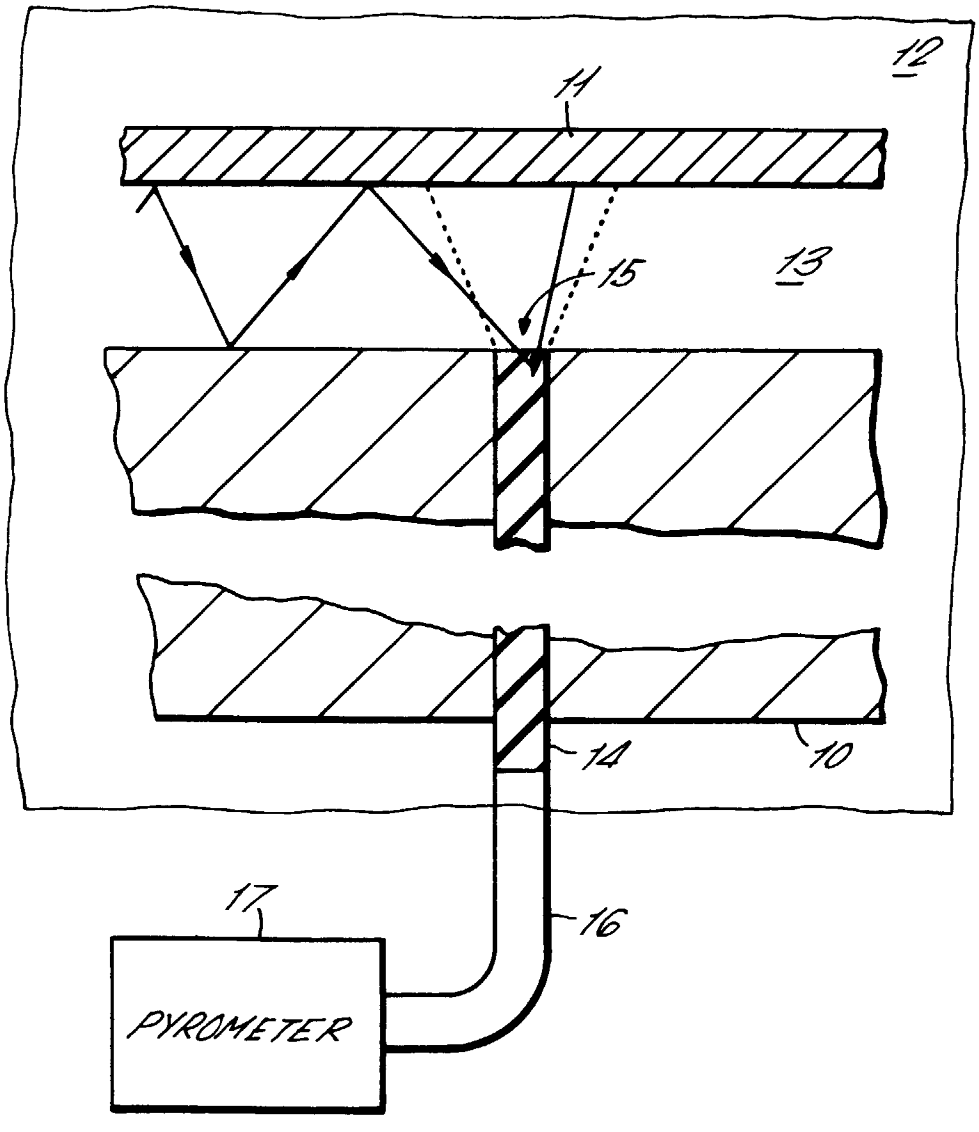

FIG. 3.

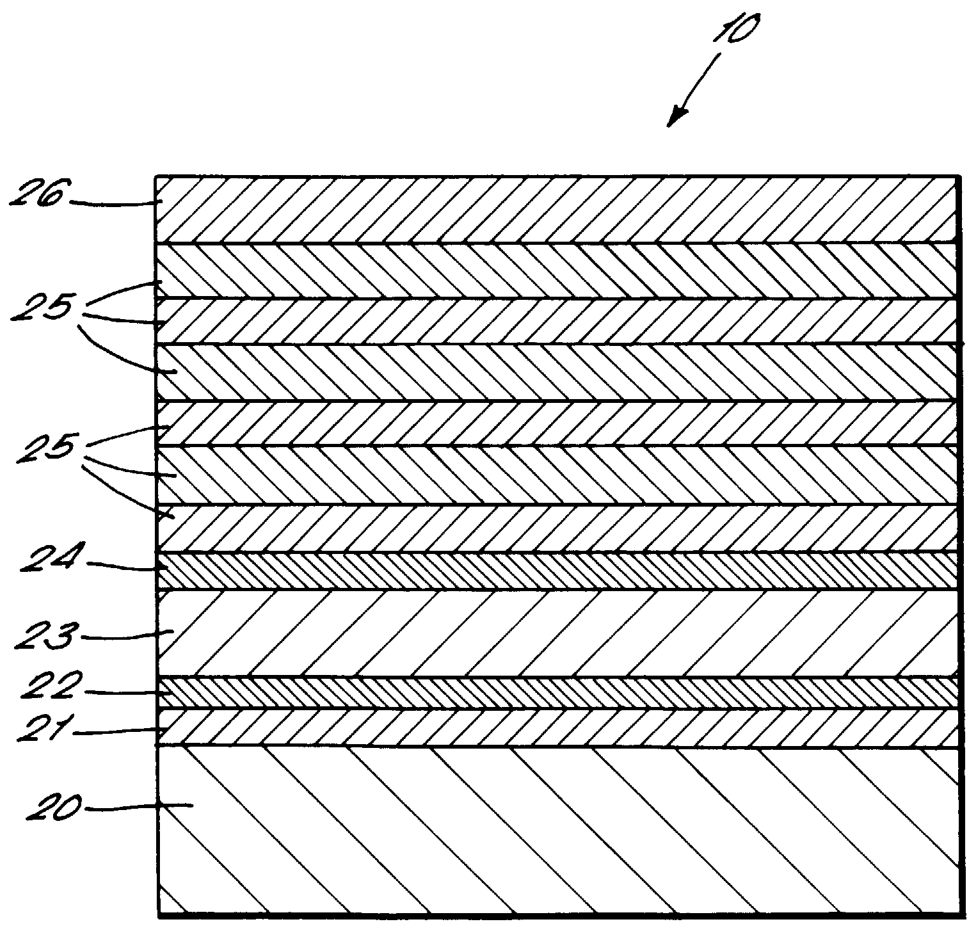

European Patent Office

# EUROPEAN SEARCH REPORT

Application Number
EP 97 30 6379

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 718 610 A (APPLIED MATERIALS INC)<br>* page 3, line 3 - line 13 *<br>* page 7, line 4 - line 19; figures *<br>--- | 1,3,5 | G02B1/10 |
| A | JP 04 133 369 A (MITSUBISHI MATERIALS CORP) 7 May 1992<br>* the whole document *<br>--- | 6-11 | |
| A | SCHERER A ET AL: "HIGH REFLECTIVITY DIELECTRIC MIRROR DEPOSITION BY REACTIVE MAGNETRON SPUTTERING"<br>JOURNAL OF VACUUM SCIENCE AND TECHNOLOGY: PART A,<br>vol. 10, no. 5, 1 September 1992,<br>pages 3305-3311, XP000305799<br>* the whole document *<br>----- | 1 | |

TECHNICAL FIELDS SEARCHED (Int.Cl.6)

G02B
G01J

The present search report has been drawn up for all claims

| Place of search | Date of completion of the search | Examiner |
|---|---|---|
| THE HAGUE | 17 November 1997 | Ramboer, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)